# EUROPÄISCHE PATENTSCHRIFT

(11) **EP 0 961 953 B1**
(45) Veröffentlichungstag und Bekanntmachung des Hinweises auf die Patenterteilung: **01.10.2003**
(21) Anmeldenummer: 98913516.5
(22) Anmeldetag: 17.02.1998
(51) Int. Cl.: G03F 7/00

(54) **CHEMISCHE MIKROREAKTOREN UND VERFAHREN ZU DEREN HERSTELLUNG**
CHEMICAL MICROREACTORS AND METHOD FOR PRODUCING SAME
MICROREACTEURS CHIMIQUES ET PROCEDE DE FABRICATION CORRESPONDANT

(30) Priorität: 20.02.1997 DE 19708472
(43) Veröffentlichungstag der Anmeldung: 08.12.1999
(73) Patentinhaber: ATOTECH Deutschland GmbH, 10553 Berlin (DE)
(72) Erfinder: BREUER, Norbert, D-71254 Ditzingen (DE); MEYER, Heinrich, D-14109 Berlin (DE)
(74) Vertreter: Effert, Bressel und Kollegen
(86) Internationale Anmeldenummer: DE9800519
(87) Internationale Veröffentlichungsnummer: WO98037457

(56) Entgegenhaltungen:
- EP-A- 0 212 878
- WO-A-92/15408
- DE-A- 3 011 282

## Beschreibung

Die Erfindung betrifft chemische Mikroreaktoren, die in der chemischen Industrie unter anderem für Syntheseverfahren eingesetzt werden konnen. Verfahren zu deren Herstellung sowie eine bevorzugte Verwendung der Mikroreaktoren.

in der Literatur wird seit einigen Jahren über chemische Mikroreaktoren berichtet, die gegenüber herkömmlichen Produktionsanlagen zur Herstellung chemischer Verbindungen Vorteile aufweisen. Bei der Umsetzung chemischer Verfahren in den großtechnischen Produktionsmaßstab besteht das grundsätzliche Problem. daß die Abmessungen der Produktionsanlagen um mehrere Größenordnungen größer sind als die im Labormaßstab zur Entwicklung der Verfahren verwendeten Geräte. Wird beispielsweise eine chemische Synthese betrachtet, so ist die relevante Größenskala der miteinander reagierenden chemischen Spezies durch deren Molekülgröße bestimmt, die im allgemeinen im Bereich von unter einem Nanometer bis zu einigen Nanometern beträgt. Für Diffusions- und Wärmetransportphanomene sind Längen von einigen Millimetern bis in den Mikrometer-Bereich relevant. Auf Grund der großtechnisch benötigten Produktionsvolumina haben chemische Reaktoren meistens Abmessungen. die in der Größe zwischen wenigen Zentimetern bis zu mehreren Metern liegen. Daher können die im Labormaßstab mit Reaktionsvolumina von wenigen Litern bis zu etwa 100 Litern gewonnenen Erkenntnisse über die Verfahrensführung zumindest für homogene chemische Reaktionen nicht direkt in den großtechnischen Maßstab übernommen werden. Bereits beim Vermischen von Flüssigkeiten ist ein Rührwerk primär dafür nötig, den Stofftransport dadurch zu vergrößern, daß die Abstände zwischen Gebieten unterschiedlicher Konzentration verringert werden. Aus den unterschiedlichen Dimensionen der Reaktoren ergibt sich auch das sogenannte scale-up-Problem. Eine chemische Reaktion, die im Labormaßstab optimiert wurde, kann danach nicht sofort auf die Produktionsanlage, sondern erst auf eine Pilotanlage mit Dimensionen zwischen dem Labor- und dem Produktionsmaßstab (Technikumsmaßstab) übertragen werden, bevor Sie schließlich in der großtechnischen Produktion eingesetzt wird. Problematisch ist, daß jede Stufe dieser Verfahrensentwicklung eines eigenen Optimierungszyklus' bedarf, wobei jeder dieser Zyklen additiv in die für die Prozeßeinführung benötigte Entwicklungsdauer eingeht. Bei der heterogenen Katalyse dagegen werden die Katalysatorpartikel oft auf poröse Träger aufgebracht, deren Porengröße in dem für den Stofftransport relevanten Größenordnungsbereich (Millimeter- bis Mikrometerbereich) liegt.

Bei nicht optimaler Verfahrensführung, die lediglich auf Kenntnissen aus dem Labormaßstab beruht, kann beispielsweise die Ausbeute einer chemischen Synthese zu gering sein, da zu große Anteile von unerwünschten Nebenprodukten wegen bevorzugt ablaufender Nebenreaktionen gebildet werden.

Um die vorgenannten Probleme bei der Übertragung eines Verfahrens vom Labor- zum Produktionsmaßstab zu lösen, wurde vor einigen Jahren das Konzept der sogenannten Mikroreaktoren entwickelt. Hierbei handelt es sich um eine parallele Anordnung mehrerer Reaktionszellen, deren Abmessungen von wenigen Mikrometern bis zu einigen Millimetern betragen. Diese Reaktionszellen werden so gestaltet, daß in ihnen physikalische, chemische oder elektrochemische Reaktionen ablaufen können. Im Gegensatz zu einem herkömmlichen porösen System (heterogene Katalyse) sind die Abmessungen der Zellen in einem Mikroreaktor definiert, also planmäßig mit einem technischen Verfahren hergestellt. Auch die Anordnung der einzelnen Reaktionszellen im Ensemble des Reaktors ist ebenfalls geordnet, insbesondere periodisch in einer oder zwei Dimensionen. Zu den Mikroreaktoren im erweiterten Sinne werden auch die notwendigen Zu- und Ableitungsstrukturen für die Fluide (Flüssigkeiten und Gase) sowie Sensoren und Aktoren gerechnet, beispielsweise Ventile, Kühl- und Heizelemente, die den Stoff- und Wärmestrom in den einzelnen Zellen kontrollieren bzw. beeinflussen.

Eine einzelne Reaktorzelle weist eine laterale Ausdehnung auf, die in der für einen optimalen Stoff- und Wärmetransport günstigen Größenordnung liegt. Da der Volumenstrom durch eine einzelne Reaktorzelle sehr klein ist, wird der gesamte Reaktor durch Parallel-Vervielfältigung dieser Elementarzelle auf das technisch notwendige Maß vergrößert (scale-out). Durch die kleinen Abmessungen werden lokale Unterschiede der Konzentration und Temperatur in den Fluidströmen auf ein minimales Maß verringert. Dadurch lassen sich die Prozesse sehr viel genauer auf die optimalen Reaktionsbedingungen einstellen, so daß die Umsatzraten bei einer chemischen Reaktion bei gleicher Verweilzeit des Reaktionsmediums im Reaktor vergrößert werden können. Darüber hinaus können die Reinheit und Ausbeute der synthetisierten Stoffe durch Einstellen nahezu günstigster Reaktionsbedingungen optimiert werden. Dadurch können auch solche chemischen Umsetzungen realisiert werden die auf herkömmlichem Wege nicht durchführbar sind, beispielsweise indem Zwischenprodukte gezielt abgefangen werden.

Zur Herstellung der chemischen Mikroreaktoren gibt es eine Reihe von Vorschlägen.

Zum einen kann ein Mikroreaktor beispielsweise durch Stapeln von mehreren Kupferfolien hergestellt werden, in die zur Bildung von Strömungskanälen mittels eines Diamantwerkzeuges Rillen eingeritzt werden. Von D. Hönicke und G. Wiesmeier wird in dem Aufsatz "Heterogeneous Catalyzed Reactions in a Microreactor" in DECHEMA Monographs Volume 132, Papers of the Workshop on Microsystem Technology, Mainz, 20. bis 21. Februar 1995, Seiten 93 bis 107 ein derartiger Mikroreaktor beschrieben, der zur teilweisen Oxidation von Propen zu Acrolein eingesetzt wird. Die einzelnen Reaktorlagen werden durch Diffusionsbonden und anschließendes Elektronenstrahlschweißen miteinander verbunden. Zur Durchführung der chemischen Reaktion war es erforderlich, Kupfer in den entstehenden Kanälen durch Teiloxidation zu Kupfer-(I)-Oxid umzuwandeln.

Zur genauen und reproduzierbaren Herstellung der feinen Strukturen wird ein für solche Zwecke geeigneter Mikropositioniertisch benötigt. Die einzelnen Reaktionszellen werden grundsätzlich seriell und damit in zeit- und kostenintensiver Weise gefertigt.

Mit dem LIGA-Verfahren (Lithographie, Galvano-Formung, Abformung) wird eine Kunststoffschicht, meistens Polymethylmethacrylat (PMMA), mittels Synchrotron-Strahlung belichtet und anschließend entwickelt. Die derart erzeugte Struktur wird elektrolytisch mit einem Metall ausgefüllt. Die Metallstruktur kann dann in weiteren Verfahrensschritten mittels einer Kunststoffreplizierung wieder abgeformt werden. Ein derartiges Verfahren wird von W. Ehrfeld und H. Lehr in Radiat. Phys. Chem., Band 45 (1995), Seiten 349 bis 365, sowie von W. Menz in Spektrum der Wissenschaft, Februar 1994, Seiten 92 bis 99, und W. Menz in Automatisierungstechnische Praxis, Band 37 (1995), Seiten 12 bis 22 beschrieben. Nach Angaben in dem Fachartikel in Spektrum der Wissenschaft a.a.O. werden einzelne Komponenten oder Subsysteme, die getrennt hergestellt werden, mit geeigneten Fügetechniken miteinander verbunden.

Eine mit dem LIGA-Verfahren verwandte Technik, die ohne die sehr aufwendige Synchrotron-Strahlung auskommt, ist das sogenannte Laser-LIGA-Verfahren. Hierbei wird die Kunststoffschicht aus PMMA mit einem leistungsfähigen UV-Laser strukturiert und anschließend wie im LIGA-Verfahren galvanisch abgeformt (W. Ehrfeld et al., "Potentials and Realization of Microreactors" in DECHEMA Monographs, Volume 132, Seiten 1 bis 29).

Von W. Menz wird in Automatisierungstechnische Praxis, a.a.O. auch ein abgewandeltes Verfahren vorgeschlagen, nach dem auf einem Siliziumsubstrat, in dem auf herkömmliche Weise eine mikroelektronische Schaltung gebildet worden ist, zuerst eine Schutzschicht, darauf eine ganzflächige Metallisierungsschicht und darauf eine Kunststofformmasse aufgebracht wird. Anschließend wird mittels einer Metallmatrix, die nach dem LIGA-Verfahren hergestellt wurde, das Abbild der Fluidkanalstrukturen in die Formmasse geprägt. Danach werden die Metallschicht überziehende Restschichten der Formmasse in den entstandenen Vertiefungen durch Plasmaätzen entfernt, und in den Vertiefungen elektrochemisch Metall abgeschieden. Die Kunststoffstrukturen werden anschließend entfernt und die freigelegten Metallbereiche der Grundmetallisierung durch Ätzen beseitigt.

Sowohl das herkömmliche LIGA-Verfahren als auch das Laser-LIGA-Verfahren sind außerordentlich aufwendig, da sie zur Strukturierung der Kunststoffschicht sehr teure Einrichtungen benötigen (Synchrotronstrahlungsquelle).

Ferner ist aus dem vorgenannten Aufsatz von W. Ehrfeld et al. "Potentials and Realization of Microreactors" ein Verfahren zum Herstellen von chemischen Mikroreaktoren bekannt, bei dem ein photoempfindliches Glas, beispielsweise FOTURAN® (Schott Glaswerke, Mainz) eingesetzt wird. Hierzu wird ein Abbild der zu erzeugenden Struktur mit UV-Licht auf den Glaskörper übertragen. Durch eine anschließende Wärmebehandlung kristallisieren ausschließlich die belichteten Bereiche im Glas. Diese können danach in einer Flußsäurelösung bevorzugt weggeätzt werden. Dieses Verfahren weist den Vorteil auf, daß die Reaktionskanäle durch die parallele Belichtung und das Ätzverfahren schnell reproduziert werden können. Allerdings können nur bestimmte Gläser eingesetzt werden, so daß diese Herstellmethode zum einen teuer und insbesondere nur auf einige Anwendungsfälle beschränkt ist.

Auch die Methoden, die in der Halbleiterindustrie zur Strukturierung von Siliziumoberflächen entwickelt worden sind, wurden zur Herstellung von Mikroreaktoren übernommen. Beispielsweise wurde von J.J. Lerou et al. in dem Fachaufsatz "Microfabricated Minichemical Systems: Technical Feasibility " DECHEMA Monographs Volume 132, Seiten 51 bis 69) ein Verfahren beschrieben, bei dem drei geätzte Silizium-Wafer und zwei End-Wafer an den Außenseiten miteinander verbunden wurden. Ferner wurde ein mit polykristallinen Silberpartikeln gefüllter Wärmeaustauscher, der ebenfalls als Mikroreaktor ausgebildet war, verwendet. Auch dieses Verfahren ist nur begrenzt einsetzbar, da ausschließlich Silizium verwendet werden kann.

Ein Verfahren zur Herstellung von Platten-Wärmeaustauschern ist in EP 0 212 878 A1 beschrieben. Danach werden die für den Wärmeaustauscher benötigten Kanalstrukturen mittels einer Maske (Siebdruck, Photodruck) auf Stahl-, Edelstahl-, Messing-, Kupfer-, Bronze- oder Aluminiumplatten gebildet und die Kanäle selbst in den durch die Maske nicht belegten Oberflächenbereichen durch ein chemisches Ätzverfahren hergestellt. Mehrere dieser Platten werden anschließend in einem Diffusionsbondverfahren miteinander verbunden. Ein derartiger Wärmeaustauscher, gebildet aus durch Diffusionsbonden miteinander verschweißten Platten, ist auch in EP 0 292 245 A1 offenbart.

Die bisher bekannten Methoden zur Herstellung von Mikroreaktoren weisen daher vielfältige Nachteile auf, unter anderem, daß nur mit einer zeitund/oder kostenintensiven Methode strukturierte Metalloberflächen im Reaktor erzeugt werden können oder ausschließlich Glas beziehungsweise Silizium eingesetzt werden können, die für bestimmte Anwendungen nicht gut geeignet sind.

Die Reaktoren nach EP 0 212 245 A1 und EP 0 292 245 A1 weisen den weiteren Nachteil auf, daß mit der dargestellten Konfiguration ausschließlich Wärmeaustauscher hergestellt werden können, so daß vielfältige Anwendungsmöglichkeiten für chemische Mikroreaktoren gar nicht in Betracht kommen. Insbesondere können mit diesem Verfahren komplexe Reaktoren nicht realisiert werden, die neben den Kanälen auch elektronische Halbleiterschaltungen, Lichtleiter sowie andere Elemente wie Aktoren und Sensoren aufweisen.

Der vorliegenden Erfindung liegt von daher das Problem zugrunde, chemische Mikroreaktoren herzustellen, die für eine Vielzahl von unterschiedlichen Anwendungen geeignet und mit unterschiedlichen und gegebenenfalls komplexen Elementen, wie elektronischen Schaltkreisen, Lichtleitern, Aktoren und Sensoren sowie katalytischen, Korrosionsschutz- oder anderen funktionellen Schichten in den Kanälen, ausgestattet sind. Das Herstellverfahren soll preiswert sein und schnell durchgeführt werden können. Insbesondere soll es auch möglich sein, derartige Mikroreaktoren in großen Stückzahlen herzustellen.

Das Problem wird gelöst durch die Verfahren nach den Ansprüchen 1 bis 3 und den chemischen Mikroreaktor nach Anspruch 16.

Zur Lösung des Problems wurden drei Herstellverfahren für chemische Mikroreaktoren gefunden, die mindestens ein Substrat mit Fluidkanälen sowie Zuund Ableitungen für Fluide aufweisen. Die Verfahren kommen ohne Anwendung von Kunststoffabformverfahren aus und weisen folgende Verfahrensschritte auf:

### Ätzverfahren:

a. Bilden von Fluidkanalstrukturen auf auf dem Substrat befindlichen Metalloberflächen mittels einer Photoresist- oder einer Siebdrucklackschicht, so daß die Metalloberflächen von der Schicht teilweise bedeckt werden;
b. zumindest teilweises stromloses und/oder elektrochemisches Abätzen von Metall von den freiliegenden Flächen des Substrats;
c. vollständiges Entfernen der Photoresist- oder Siebdrucklackschicht;
d. Bilden von Lotschichten;
e. Übereinanderlegen der Substrate und eines die Fluidkanäle verschließenden Abschluß-Segments und Miteinanderverbinden der Substrate und des Abschluß-Segments durch Löten.

### Umkehrverfahren:

a. Bilden von Fluidkanalstrukturen auf auf dem Substrat befindlichen Metalloberflächen mittels einer Photoresist- oder einer Siebdrucklackschicht, so daß die Metalloberflächen von der Schicht teilweise bedeckt werden;
b. stromloses und/oder elektrochemisches Abscheiden einer Metallschicht auf die freiliegenden Oberflächen des Substrats;
c. vollständiges Entfernen der Photoresist- oder Siebdrucklackschicht;
d. zumindest teilweises stromloses und/oder elektrochemisches Abätzen des Metalls des Substrats unter Bildung von Fluidkanälen;
e. Bilden von Kleb- und/oder Lotschichten;
f. Übereinanderlegen der Substrate und eines die Fluidkanäle verschließenden Abschluß-Segments und Miteinanderverbinden der Substrate und des Abschluß-Segments durch Kleben und/oder Löten.

### Additivverfahren:

a. Bilden von Fluidkanalstrukturen auf auf dem Substrat befindlichen Metalloberflächen oder direkt auf dem Substrat mittels einer Photoresist- oder einer Siebdrucklackschicht, so daß die Substratoberflächen oder Metalloberflächen auf dem Substrat von der Schicht teilweise bedeckt werden;
b. Abscheiden einer Metallschicht auf die freiliegenden Oberflächen des Substrats oder auf die Metalloberflächen;
c. vollständiges Entfernen der Photoresist- oder Siebdrucklackschicht;
d. Bilden von Kleb- und/oder Lotschichten;
e. Übereinanderlegen der Substrate und eines die Fluidkanäle verschließenden Abschluß-Segments und Miteinanderverbinden der Substrate und des Abschluß-Segments durch Kleben und/oder Löten.

Die erfindungsgemäßen chemischen Mikroreaktoren weisen folgende Merkmale auf:
a. Fluidkanäle in mindestens einer Ebene;
b. Zu- und Ableitungen für Fluide;
c. die Fluidkanäle sind durch einander gegenüberliegende Seitenwände aus Metall und durch weitere, sich zwischen diesen Seitenwänden erstreckende Seitenwände aus Metall oder Kunststoff begrenzt;
d. Unterschiedliche Fluidkanalebenen sind untereinander und/oder mit einem offenliegende Fluidkanäle verschließenden Abschluß-Segment mittels geeigneter Lotschichten verbunden.

Eine vorteilhafte Verwendung der chemischen Mikroreaktoren ist in Anspruch 20 angegeben. Danach sind die Reaktoren zur Herstellung giftiger, instabiler oder explosiver chemischer Produkte, insbesondere von Chlorcyan, Phosgen, Ethylenoxid, Selenverbindungen, Mercaptanen, Methylchlorid, Methyljodid, Dimethylsulfat, Vinylchlorid und Phosphinen, geeignet.

Vorteilhafte Ausführungsformen der Erfindung sind in den Unteransprüchen angegeben.

Durch Anwendung von galvanotechnischen Verfahren zur Herstellung der einzelnen Reaktorebenen ist eine sehr flexible Anpassung an den jeweiligen Anwendungsfall durch Wahl geeigneter Materialkombinationen für die Ebenen möglich.

Dadurch wird auch die Möglichkeit eröffnet, die Verbindung der strukturierten Reaktorebenen in einen Gesamtprozeß zu integrieren, um gestapelte Reaktoren herstellen zu können. Es wird nicht, wie bei der Verwendung von Kupferfolien, ein Diffusionsschweißverfahren, das eine hohe Temperaturbelastung für die Reaktorkomponenten darstellt, oder bei Verwendung von Silizium-Wafern ein anodisches Bondverfahren eingesetzt. Vielmehr werden die einzelnen Reaktorebenen durch Löten oder gegebenenfalls Kleben miteinander verbunden. Dadurch können einzelne Ebenen des Mikroreaktors bereits mit mittlerer Temperaturbelastung der Substrate zu Stapeln zusammengefügt werden, so daß temperaturempfindliche Substrate sowie bereits vor dem Zusammenfügen integrierte temperaturempfindliche Reaktorelemente, beispielsweise Halbleiterschaltungen oder quellbare Gele zur Bildung von Aktoren eingesetzt werden können. Die Löttemperatur kann auch durch Wahl bestimmter Lote auf geringe Werte gesenkt oder die Festigkeit des Stapels bei Wahl bestimmter Hartlote auf hohe Werte eingestellt werden. Durch Wahl niedrigschmelzender Lote oder durch Kleben ist es möglich, auch temperaturempfindliche Substratoberflächen für die Anwendung bei der chemischen Synthese vor dem Zusammenfügen der Reaktorebenen zu präparieren.

Die innere Oberfläche des erfindungsgemäßen Reaktors kann auch nach dem Zusammenfügen noch chemisch oder strukturell verändert und dadurch gemäß den Anforderungen des spezifischen chemischen Verfahrens optimiert werden. Des weiteren besteht die Möglichkeit, zusätzlich zu den Metallschichten auch beliebige Kunststoffschichten in den Reaktor zu integrieren, da Verbundmaterialien von Metallen mit Kunststoffen in einer fast unbegrenzten Anzahl zur Verfügung stehen. Die verwendeten Materialien können somit an die spezifischen Anforderungen des jeweiligen Anwendungsfalles angepaßt werden.

Die herstellbaren Kanäle können sehr gleichmäßig erzeugt werden. Eine Gratbildung wie beim mechanischen Ritzen von Kupferfolien und ein Werkzeugverschleiß tritt nicht auf. Die Abmessungen der Fluidkanäle liegen vorzugsweise im Bereich von 1 mm oder darunter. Beispielsweise können Fluidkanäle mit etwa rechteckigem Querschnitt auch mit einer Breite von 100 µm und einer Höhe von 40 µm hergestellt werden. In besonders bevorzugten Ausführungsformen der Erfindung weisen die Fluidkanäle Strukturhöhen von 300 µm und darunter auf. Im Falle von nicht rechteckigem Querschnitt der Kanäle sollen sich die Breitenangaben auf auf halber Höhe der Kanäle gemessene Breitenabmessungen beziehen. Beispielsweise können auch im Querschnitt etwa halbkreisförmige, konkave Kanäle gebildet werden.

Ein weiterer wesentlicher Vorteil besteht darin, alle Reaktorebenen gleichzeitig herstellen zu können. Es ist nicht erforderlich, die einzelnen Verfahrensstufen nacheinander zu durchlaufen. Da die einzelnen Kanalebenen bzw. Module im wesentlichen gleichzeitig erzeugt werden können, kann der gesamte Reaktor mit geringeren Toleranzen hergestellt werden. Es wird zudem eine hohe Reproduzierbarkeit der Grundstrukturen ermöglicht.

Die hergestellten Reaktoren sind billig, da keine übermäßig aufwendigen Vorrichtungen für den Herstellprozeß erforderlich sind. Die beim LIGA-Verfahren gebildeten Resiststrukturen weisen zwar eine extreme Kantensteilheit und ein sehr großes Aspektenverhältnis auf. Während diese Eigenschaften für die Herstellung von mikromechanischen Komponenten, für die dieses Verfahren ursprünglich entwickelt worden ist, unerläßlich sind, sind sie für die Herstellung von chemischen Mikroreaktoren entbehrlich. Unter Vermeidung der teuren Synchrotronstrahlung bzw. der teuren UV-Laservorrichtungen und der hierfür erforderlichen teuren Masken können auf photolithographischem Wege oder sogar mittels Siebdruck Strukturen erzeugt werden, mit denen die Anforderungen an die mittleren Dimensionen bei Mikroreaktoren erfüllt werden können.

Gegenüber den in EP 0 212 878 A1 und EP 0 292 245 A1 beschriebenen Wärmeaustauschern bzw. dem Herstellverfahren weisen die erfindungsgemäßen Reaktoren und Herstellverfahren den Vorteil auf, daß temperaturempfindliche Materialien eingesetzt werden können, da das Diffusionsbondverfahren nicht eingesetzt wird. Es können insbesondere auch Halbleiterschaltungen, Lichtleiter, Aktoren und Sensoren sowie temperaturempfindliche Beschichtungen bereits vor dem Zusammenfügen in den Reaktor integriert werden. Dies führt zu einer wesentlichen Erweiterung der möglichen Anwendungsbreite und Erleichterung beim Design und der Fertigungsstrategie der Reaktoren.

Aus den vorgenannten Gründen ist das erfindungsgemäße Verfahren außerordentlich flexibel einsetzbar. Die Einzelkomponenten können in großer Stückzahl, preiswert und mit hoher Maßgenauigkeit hergestellt werden.

Als chemische Mikroreaktoren werden Vorrichtungen mit Fluidkanälen aus mindestens einer Reaktorlage verstanden, die neben den eigentlichen Reaktionszonen gegebenenfalls auch Hilfszonen aufweisen, die zum Mischen. Dosieren, Heizen, Kühlen oder Analysieren der Ausgangsstoffe, von Zwischenprodukten oder der Endprodukte dienen. Jede Zone ist durch einen an die jeweiligen Anforderungen angepaßten Aufbau charakterisiert. Während Heiz- und Kühlzonen entweder als Wärmetauscher oder als mit elektrischen Widerstandsheizungen bzw. mit elektrischen Kühlelementen ausgerüstete Reaktorabteile ausgebildet sind, weisen Analysenzonen angepaßte Sensoren auf, Dosierzonen enthalten beispielsweise Mikroventile und Mischzonen, beispielsweise Kanäle mit geeignet geformten Einbauten zur Verwirbelung der zusammengeführten Fluide. Der Aufbau der erfindungsgemäßen Mikroreaktoren kann für bestimmte Anwendungsfälle auch derart konzipiert sein, daß ausschließlich Wärme von oder zu dem fluidischen Medium transportiert wird, beispielsweise indem Wärme zwischen dem zu heizenden oder zu kühlenden Medium und einem anderen Heiz- bzw. Kühlmedium ausgetauscht wird. Die Fluidkanäle in den einzelnen Reaktorlagen werden im allgemeinen durch Übereinanderstapeln mehrerer Lagen und die letzte Lage mit einem Abschluß-Segment verschlossen.

Zur Herstellung der Mikroreaktoren können unterschiedliche Substrate eingesetzt werden: Zum einen sind hierzu Metallfolien geeignet, beispielsweise Stahl-, Edelstahl-, Kupfer-, Nickel- oder Aluminiumfolien. Deren Dicke sollte im Bereich von 5 µm bis 1 mm liegen. Folien mit einer Dicke unter 5 µm sind weniger gut geeignet, da in ihnen keine ausreichend weiten Kanäle gebildet werden können. Wird als Substrat eine reine Metallfolie verwendet, so ergibt sich bei derartig geringen Metallschichtdicken das weitere Problem, daß diese Folien nur noch äußerst schwierig handhabbar sind. Folien mit einer Dicke über 1 mm würden dagegen zu einem dicken Reaktorstapel führen.

Des weiteren sind auch mit Metall ein- oder zweiseitig beschichtete Kunststoff-, Keramik- oder Glasfolien als Substrate einsetzbar. Beispielsweise sind mit Kupferfolien kaschierte Epoxidharz- oder Polyimidlaminate geeignet. Eine Möglichkeit zur Erzeugung der mit Metall beschichteten Kunststoffolien besteht auch darin, diese mit bekannten chemischen Methoden zu metallisieren. Hierzu muß die Folie zunächst mittels chemischer oder physikalischer Verfahren oberflächlich vorbehandelt werden, indem diese beispielsweise in Ätzlösungen oder mittels einer Plasmaentladung unter Verwendung geeigneter Gase aufgerauht wird. Anschließend werden die Kunststoffolien nach geeigneter weiterer Vorbehandlung, beispielsweise einer Reinigung, Konditionierung und Aktivierung stromlos und/oder elektrochemisch metallisiert. Die Stabilität der Kunststoffschicht, insbesondere von Epoxidharz, wird häufig durch Einbetten von Glasfaser- oder Aramidgeweben vergrößert. Eine andere Möglichkeit besteht darin, Kunststoff- und Metallfolien unter Druck und Temperatureinwirkung miteinander zu verpressen (Laminieren).

Andere chemisch beständige Materialien sind unter anderem Polytetrafluorethylen oder andere halogenierte Polyalkane. Derartige chemisch beständige Materialien lassen sich beispielsweise durch plasmaunterstützte chemische Gasphasenabscheidung (PECVD) aktivieren. Auf solchen aktivierten Oberflächen können durch stromlose Metallabscheidung beispielsweise haftfeste Nickel/Phosphor- oder Kupferschichten gebildet werden. Auch die haftfeste Beschichtung von Glas- oder Keramikwerkstoffen ist nach bekannten Verfahren ohne weiteres möglich, beispielsweise durch alkalisches Anätzen vor dem Aktivieren und stromloses Metallisieren. Durch die Beschichtung der chemisch beständigen Kunststoffe mit Metallen können diese Materialien leichter haftfest miteinander verbunden werden. Ein derartiger Verbund der Polytetrafluorethylenfolien ist mit nicht metallisierten Laminaten nicht ohne weiteres möglich.

Zur Bildung der Fluidkanäle können verschiedene Verfahren eingesetzt werden. In einer Verfahrensweise wird von ganzflächig mit Metall, beispielsweise Kupfer, beschichteten Substraten ausgegangen. Die hierfür geeigneten Verfahren zur Bildung der Kanäle sind zuvor schematisch dargestellt worden. Nach einer anderen Verfahrensvariante können die Fluidkanäle auch durch additives Aufbauen der Metallschichten ausschließlich in den Bereichen auf den Substraten erzeugt werden, die nicht den Kanalstrukturen entsprechen. Hierfür stehen ebenfalls die erfindungsgemäßen Verfahren zur Verfügung.

Um ausreichend tiefe Fluidkanalstrukturen zu erhalten, muß die abzuätzende oder abgeschiedene Metallschicht ausreichend dick sein. Da häufig Probleme bei der gleichmäßigen Herstellung von dicken Metallschichten, insbesondere auf großflächigen Substraten, bestehen, werden vorzugsweise kleine Substratnutzen, auf denen die Kanäle gebildet werden, eingesetzt.

Zum Bilden der Fluidkanäle mit der Ätztechnik wird die Resistschicht (Siebdruck- oder Photoresistschicht) so auf die Substratoberflächen aufgebracht, daß die die Fluidkanäle bildenden Oberflächenbereiche von der Resistschicht nicht bedeckt sind.

Zum additiven Erzeugen der Fluidkanäle kann auch von nicht mit Metall beschichteten Folien ausgegangen. In diesem Fall wird zunächst eine Siebdruck- oder Photoresistschicht auf die Folienoberflächen derart aufgebracht, daß die den Fluidkanälen entsprechenden Oberflächenbereiche vom Resist bedeckt sind. Gleiches gilt auch im Falle der Umkehrtechnik. Um bei Anwendung der Additivtechnik eine stromlose Metallabscheidung zu ermöglichen, müssen die Folienoberflächen zunächst in geeigneter Weise vorbehandelt werden. Hierzu werden dieselben Verfahren angewendet wie zur ganzflächigen Metallisierung der Folien. Anschließend können die Metallstrukturen in den freiliegenden Bereichen der Photoresistschicht auf den Folienoberflächen abgeschieden werden. Beispielsweise können die typischen Verfahren aus der Leiterplattentechnik eingesetzt werden. Hierzu wird ausdrücklich auf die diesbezüglichen Angaben im "Handbuch der Leiterplattentechnik", Band III, Hrgb. G. Herrmann, Seiten 61 bis 119, 1993, Eugen G. Leuze Verlag, Saulgau, DE, verwiesen. Die dort enthaltenen Angaben zur Verfahrenstechnik sind auch hier anwendbar und werden hiermit einbezogen. Nach der Metallabscheidung wird die Photoresistschicht vollständig entfernt.

Als Fluide werden in den fertiggestellten Mikroreaktoren Flüssigkeiten und Gase prozessiert.

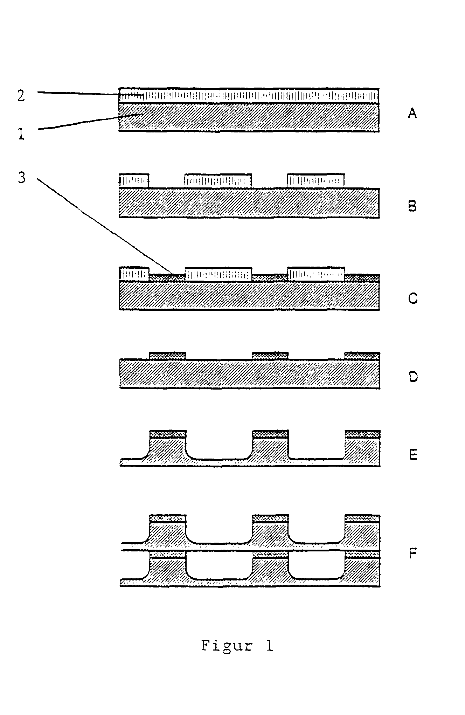

Auf den Substraten werden nach dem erfindungsgemäßen Verfahren zunächst Fluidkanalstrukturen gebildet, wobei ein Siebdruckverfahren oder insbesondere ein photolithographisches Verfahren eingesetzt wird. Hierzu wird auf eine oder beide Oberflächen der Folie ein Photoresist aufgebracht. Im Schema der Figur 1 ist ein Verfahren zur Bildung der Strukturen beispielhaft dargestellt (Umkehrtechnik). Der Photoresist 2 kann entweder als Film auf das Substrat 1 auflaminiert, als Flüssigkeit mit der spin-coating- oder der Vorhangtechnik oder durch Elektroabscheidung aufgetragen werden (Verfahrensschritt A in Figur 1). Danach wird die Photoresistschicht mit dem Abbild der zu erzeugenden Fluidkanalstruktur belichtet und die Struktur anschließend in einem Entwicklungsprozeß herausgearbeitet (Verfahrensschritt 2).

Neben den Fluidkanalstrukturen können auch andere Funktionen auf den Substraten vorgesehen werden. Zum einen können sogenannte Aktoren und Sensoren in den Mikroreaktor integriert werden. Bei den Aktoren handelt es sich um extern oder durch Meßsignale automatisch ansteuerbare Schaltglieder, beispielsweise Ventile, aber auch elektrische Widerstandsheizungen oder nach dem Peltiereffekt funktionierende Kühlelemente. Ventile können beispielsweise aus quellbaren Gelpfropfen gebildet werden. Mikroreaktoren, in denen Aktoren und Sensoren vorgesehen sind, lassen sich bei geeigneter regelungstechnischer Verknüpfung von Aktoren und Sensoren lokal optimieren. Gleichzeitig können Sensorausgänge auch für die externe Überwachung des Reaktorzustands (wie beispielsweise die Alterung, Vergiftung von Katalysatoren und ähnliche Parameter) verwendet werden.

Für die Aktoren und Sensoren sind gegebenenfalls auch elektrische Verbindungsleitungen zur Ansteuerung oder zur Erfassung von Meßsignalen auf den Substraten vorzusehen. Für diese Elemente müssen jeweils geeignete Strukturierungselemente beim Photoprozeß berücksichtigt werden.

Werden mit Metall beschichtete Substrate eingesetzt, so können in das Innere von Mikroreaktoren auch andere Elemente integriert werden. Beispielsweise können Mikrochips zur Steuerung von Aktoren und Sensoren integriert werden, indem in einem Kunststofflaminat eine Aussparung vorgesehen wird, in die der Mikrochip eingelassen wird. Die elektrischen Verbindungen zu entsprechenden Steuer- und Signalleitungen können durch Bonden oder andere bekannte Verbindungstechniken, wie beispielsweise durch Löten oder Kleben mit Leitklebern hergestellt werden.

Ferner können bei der Bildung der Strukturen zusätzlich zu den Reaktionszellen gleichzeitig auch periphere Reaktorkomponenten, wie Zuleitungen, Mischzonen, Heiz- oder Kühlkreisläufe gebildet werden, so daß der Herstellaufwand verringert wird. Daher sind diese Elemente beim Photostrukturieren bereits vorzusehen. Außerdem werden auch die üblicherweise auftretenden Dichtungsprobleme minimiert.

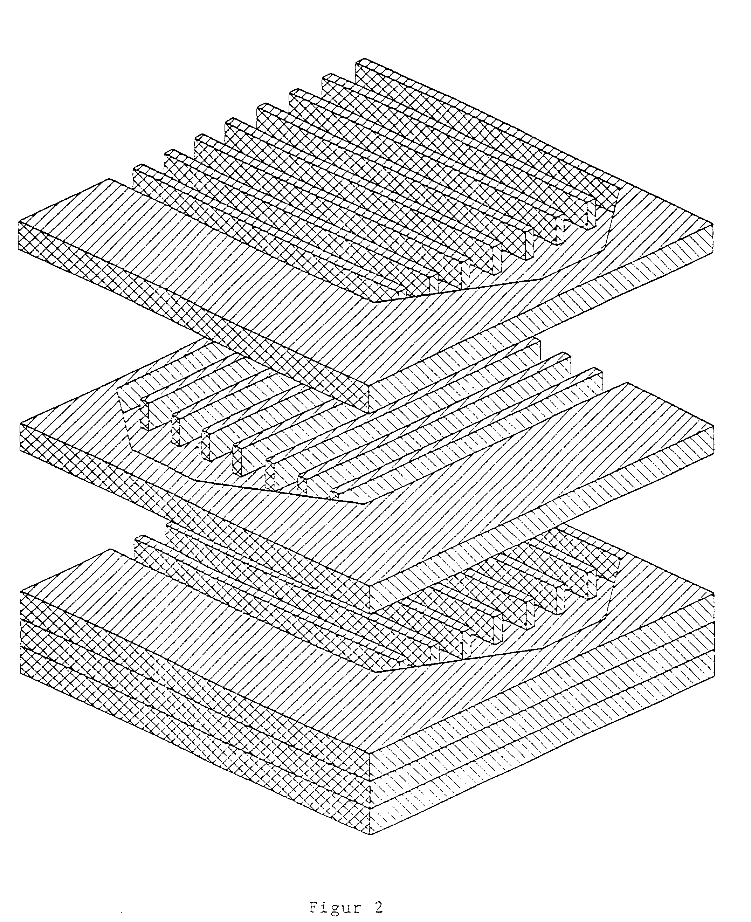

Die einzelnen Ebenen des Reaktors können vorzugsweise im Mehrfachnutzen hergestellt werden. Hierzu werden die einzelnen Ebenenbilder auf einer größeren Platte oder Folie als nebeneinander liegende Felder gebildet. Diese Elemente werden nach der Fertigstellung voneinander getrennt und können anschließend in einem Stapel zusammengefügt werden. In Figur 2 ist die Anordnung mehrerer Ebenen zu einem Stapel mit kreuzweise zueinander angeordneten, identischen Fluidkanalstrukturen, dargestellt, wobei die drei unteren Ebenen bereits miteinander verbunden sind.

Anschließend können die nun freiliegenden Metallbereiche, die nicht vom Resist bedeckt sind, weiterbearbeitet werden. Hierzu stehen stromlose oder elektrochemische Verfahren zur Verfügung. Vorzugsweise wird entweder das Material der Metallfolie zumindest teilweise abgetragen, um die Kanäle zu bilden, oder es werden weitere Metallschichten auf den freiliegenden Bereichen der Folie durch stromlose oder elektrochemische Verfahren oder durch eine Kombination dieser Verfahren aufgebaut (Figur 1). Beim erstgenannten Verfahren werden die Fluidkanalstrukturen derart gebildet, daß die den Kanälen entsprechenden Bereiche beim Entwickeln des Photoresists freigelegt werden. Beim Umkehrverfahren werden diese Bereiche dagegen vom Photoresist bedeckt gehalten, während die übrigen, nicht die Kanalstrukturen betreffenden Bereiche freigelegt werden.

Nach einer Verfahrensvariante der Umkehrtechnik wird auf den freiliegenden Bereichen der Metalloberfläche eine Metallresistschicht 3, die von der Grundmetallschicht verschieden ist, aufgebracht (Verfahrensschritt C in Figur 1). Vorzugsweise wird eine Zinn-, Blei-, Blei/Zinn-Legierungs-, Wismut-, Zinn/Wismut-Legierungs-, Nickel- oder Kobaltschicht oder eine Legierung von Nickel und Kobalt oder eine Legierung dieser Elemente mit anderen Elementen wie Bor oder Phosphor aufgetragen. Durch Verwendung dieser Metalle können die unter den Photoresistschichten liegenden Metallschichten nach dem Entfernen der Photoresistschicht geätzt werden, ohne daß die Metallresistschichten angegriffen werden. Das Verfahren bietet den Vorteil, daß die Photoresistschicht gegenüber der Ätzlösung keine ausgezeichnete chemische Beständigkeit aufweisen muß.

Nachdem die Metallschicht in den freiliegenden Bereichen nach dem Ätztechnik-Verfahren zumindest teilweise abgeätzt worden ist, oder nachdem die Metallresistschicht nach der Umkehrtechnik aufgetragen worden ist, wird die Photoresistschicht entfernt (Verfahrensschritt D in Figur 1). Nach der Umkehrtechnik werden die Substrate dann in einem Ätzbad behandelt, das das Substratmaterial angreift, nicht jedoch die Metallresistmaske (Verfahrensschritt E). Nach der Ätztechnik wird das Substrat nach dem Bilden der Fluidkanalstrukturen in der Photoresistschicht geätzt. In beiden Fällen werden dadurch Strukturen aus dem Substrat herausgearbeitet. Durch das Abtragen des Metalls der Metallfolie oder der Metallbeschichtung werden die Fluidkanäle gebildet.

Anschließend können mehrere derart hergestellte Reaktorebenen übereinander gestapelt und miteinander verbunden werden (Verfahrensschritt F).

Wird als Metallresist ein lötfähiges Metall eingesetzt, so wird bei diesem Verfahren gleichzeitig eine Schicht erhalten, die das nachfolgende Zusammenfügen der strukturierten Lagen zu einem Stapel erleichtert. Eine mögliche Kombination ist die Verwendung von Kupfer als Folienmaterial bzw. als Metallbeschichtung und Zinn bzw. eine Zinn/Blei-Legierung als lötfähiger Metallresist. Das galvanische Aufbringen von Silber enthaltendem Lot, das auch für das Hartlöten eingesetzt wird, ist ebenfalls möglich.

Bei Anwendung des Umkehr-Verfahrens besteht eine andere Verfahrensweise zur Bildung derartiger lötfähiger Schichten darin, auf den von der Photoresistschicht nicht bedeckten, freiliegenden Flächen der Metallfolie oder der Metallbeschichtung eine Zinnschicht aufzubringen, auf die wiederum Wismut abgeschieden wird. Bringt man derartig beschichtete Flächen beim Stapeln der einzelnen Reaktorebenen zusammen und erhitzt den Stapel, so bildet sich an der Grenzfläche zwischen Wismut und Zinn ein niedrig schmelzendes eutektisches Gemisch. In diesem Gemisch sind etwa 58 Gew.-% Wismut enthalten. Die Mischung weist eine Schmelztemperatur von unter 140 °C auf. Die Ebenen lassen sich beim Schmelzpunkt der eutektischen Legierung miteinander verlöten. Anschließend wird die Verbindung getempert, wobei Wismut weiter in das Zinn hinein diffundiert. Damit ändert sich die Zusammensetzung der Legierung, so daß sich der Schmelzpunkt der Metallschicht erhöht. Eine derartig hergestellte Lötverbindung bleibt deshalb nach dem Tempern weit über der ursprünglichen Löttemperatur beständig. Für das spätere Zusammenfügen des Reaktorstapels ergibt sich daher der zusätzliche Vorteil, daß das Aufbringen einer lötfähigen und temperaturbeständigen Schicht einfach in den Gesamtprozeß integriert werden kann. Außerdem kann auch auf Bereiche der einen Seite der Ebenen Zinn und auf die entsprechenden Bereiche der anderen Seite Wismut aufgebracht werden, die beim Stapeln aufeinander zu liegen kommen, so daß sich beim Erhitzen wiederum das niedrigschmelzende Eutektikum bildet. Selbstverständlich können auch andere Metalle als Zinn und Wismut eingesetzt werden, die Eutektika bilden.

Weiterhin können auf den Metalloberflächen weitere Metallschichten abgeschieden werden, sofern spezifische Anforderungen des jeweiligen Anwendungsfalles dies voraussetzen. So lassen sich beispielsweise besonders verschleißbeständige Schichten gegen Korrosion und Abrasion, beispielsweise aus Chrom, einer Nickel/Phosphor-Legierung oder Palladium, oder Oberflächen aus katalytisch aktivem Metall oder deren Verbindungen (beispielsweise Platin, Palladium, Rhodium, lridium, Ruthenium, Kupfer, Silber, Eisen, Nickel, Kobalt, Vanadin, Chrom, Wolfram, Molybdän, deren Legierungen und deren Verbindungen, beispielsweise Komplexe) elektrolytisch oder stromlos auf den Oberflächen der Fluidkanäle und/oder des Abschluß-Segments abscheiden. Die katalytisch aktiven Metalle, Legierungen und Verbindungen können auch auf Oxidoberflächen aufgebracht werden. Hierzu wird der Träger, beispielsweise aus Kupfer oder Aluminium, oberflächlich oxidiert und nachträglich werden die katalytischen Beschichtungen gebildet. Auch magnetische Schichten, beispielsweise aus einer ferromagnetischen Nickel/Kobalt-Legierung kann für bestimmte Anwendungen, wie beispielsweise für den Einsatz von Magnetventilen als Aktoren, notwendig sein. Weiterhin kann die Oberflächenstruktur auch durch Ätztechniken aufgerauht oder geglättet werden.

Zur Erzeugung komplexer dreidimensionaler Fluidkanalstrukturen im Mikroreaktor müssen gegebenenfalls Verbindungen zwischen den verschiedenen Kanalebenen gebildet werden. Hierzu ist eine durchgehende Strukturierung des Substratmaterials erforderlich. Diese kann vor dem Montieren der einzelnen Ebenen zu einem Stapel entweder in einem seriellen Prozeß, wie beispielsweise durch Laserbohren oder mechanisches Bohren, verwirklicht werden. Alternativ besteht auch die Möglichkeit, in einem zweiten Photostrukturierungsprozeß nach der Bildung der Fluidkanäle die Stellen der Reaktorebenen ungeschützt zu lassen, die in einem zweiten Ätzprozeß weiter abgetragen werden, bis das Substratmaterial an dieser Stelle eine durchgehende Verbindung zur gegenüberliegenden Seite des Substrats aufweist.

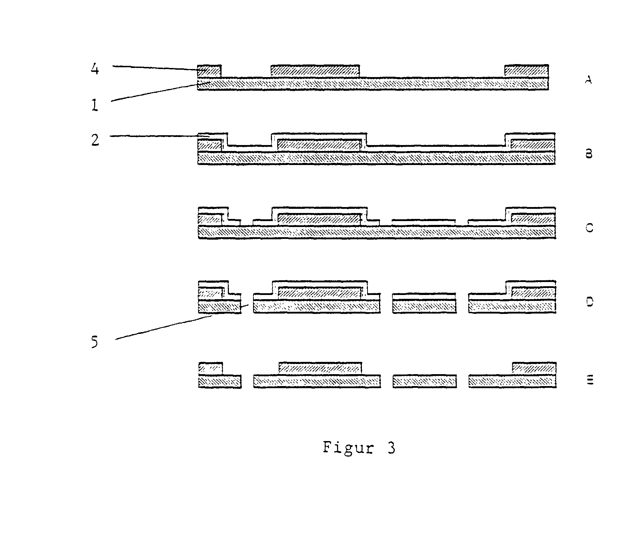

In Figur 3 ist die Bildung von durchgehenden Lochungen durch das Substratmaterial schematisch gezeigt. Danach wird das Substrat, beispielsweise mit einem Metallkern 1 und aus Metall bestehenden Strukturen 4, mit einer Photoresistschicht 2 überzogen (Verfahrensschritt B in Figur 3). Diese wird durch Belichten mit einem geeigneten Layout belichtet und entwickelt, so daß an den Stellen, an denen die Durchgangslochungen gebildet werden sollen, freiliegende Bereiche des Metallkerns entstehen (Verfahrensschritt C). Anschließend wird der Metallkern unter Bildung von Durchgangslochungen 5 geätzt (Verfahrensschritt D) und danach die Photoresistschicht wieder entfernt (Verfahrensschritt E).

Derartige Ätzverfahren können auch eingesetzt werden, um in einzelnen Lagen des aus mehreren Substraten bestehenden Mikroreaktors das Metall durch Abätzen in begrenzten Bereichen vollständig zu entfernen. Damit können lichtdurchlässige Fenster gebildet werden, beispielsweise um einen Lichtstrahl von einer Lichtquelle durch einen Fluidkanal zu leiten. Mittels derartiger Fenster, die vorzugsweise durch eine transparente Lage eines Kunststoffes gebildet werden, um den Flüssigkeitsdurchtritt zu verhindern, können Analysen mittels einer Lichtabsorptions- oder -emissionsmessung durchgeführt werden, wenn zusätzlich ein geeigneter Lichtsensor vorgesehen ist. Derartige Sensoren können auch durch lichtleitende Lagen innerhalb der Ebenen realisiert werden.

Bei der Verwendung von reinen Metallfolien kommen als Ätzverfahren vor allem chemische und elektrochemische Verfahren zum Einsatz. Für Kupferfolien kann beispielsweise eine salzsaure Lösung von Kupfer(I)-chlorid oder Eisen(III)-chlorid verwendet werden. Für Aluminiumfolien ist eine alkalische Lösung geeignet. Bei Verwendung von Kunststoffträgern, beispielsweise aus Polyimid, kann ein chemisches Verfahren mit alkalischen Ätzlösungen, ein Plasma- oder Laserätzverfahren eingesetzt werden. Auch die Durchgänge zwischen den Reaktorebenen können im Mehrfachnutzen gebildet werden, so daß wiederum der Vorteil der Zeitersparnis und der Gleichmäßigkeit des Ätzverfahrens für alle Durchgangslochungen besteht. Im Gegensatz zu mechanischen Bohrvorrichtungen können Ätzvorrichtungen ohne Probleme kontinuierlich betrieben werden. Eine Produktionsunterbrechung durch den Defekt eines Werkzeugs, wie häufig beim Bohren, kann ausgeschlossen werden.

Zudem erlaubt die Photostrukturierung die Erzeugung von Verbindungskanälen, die wesentlich kleiner sind als die durch mechanisches Bohren erzeugten Kanäle. Er erlaubt den Aufbau eines feinstrukturierten dreidimensionalen Verbindungsnetzwerkes. Dies ist notwendig, wenn ein Reaktorstapel nicht nur aus der Schichtung identischer Reaktorkammern besteht, sondern zusätzliche Komponenten, beispielsweise für die chemische Analyse oder zur kontrollierten Dosierung weiterer Substanzen, enthält. Insgesamt ist es daher von Vorteil, wenn die Technik zur Verknüpfung der einzelnen Ebenen untereinander die gleiche strukturelle Vielfalt und Präzision erlaubt, wie sie bei der Strukturierung der Ebenen verwendet wird.

Bevorzugt werden größere Nutzen des Substrats mit mehreren Ebenenelementen des Reaktors in einer Durchlaufanlage mit horizontalem Transport bearbeitet. Derartige Anlagen sind aus der Leiterplattenfertigung bekannt. Dadurch wird eine gleichmäßige und schnelle Behandlung aller durchlaufenden Substrate erreicht.

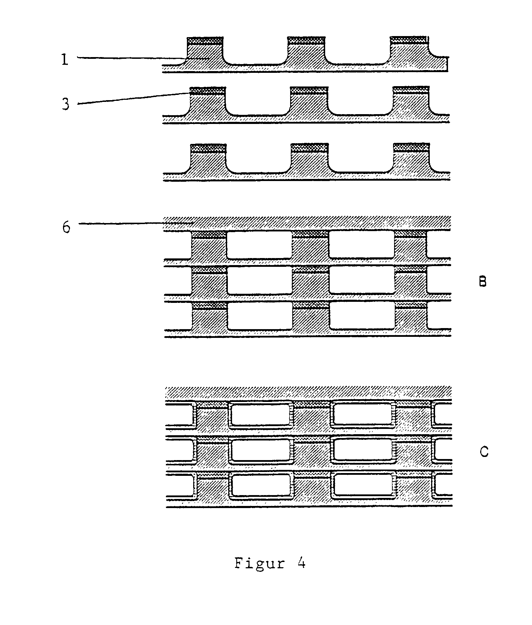

Zur Anpassung an die gewünschte Durchflußmenge des Fluids muß eine geeignete Anzahl von Ebenen in einen Stapel integriert werden. In Figur 4 ist die Bildung eines Stapels aus drei Elementen dargestellt. Ausgehend von einzelnen Lagen 1 und einem die Fluidkanäle verschließenden Abschluß-Segment 6 wird ein Stapel gebildet, der danach beispielsweise durch Erhitzen mittels der Lotschicht 3 verlötet wird (Verfahrensschritt B in Figur 4). Solche Stapel können dann wieder als Reaktormodule betrachtet und gegebenenfalls zu größeren Blöcken zusammengeschaltet werden.

Beim Zusammenfügen der Reaktorebenen zu Stapeln müssen zwei Voraussetzungen erfüllt werden: zum einen das Fixieren der Ebenen gegeneinander und zum anderen das Abdichten der durchströmten Strukturen. Günstig ist es, die Stapel mit Frontplatten abzuschließen, die so ausgelegt sind, daß sie die beim Betrieb des Reaktors unter Überdruck entstehenden Kräfte aufnehmen können. Mehrere Ebenen werden derart zu einem Stapel integriert, daß die Ebenen gegeneinander paßgenau fixiert und abgedichtet werden. Hierzu werden geeignete Registrierungselemente verwendet. Besonders geeignet sind die aus der Leiterplatten- und Halbleiterfertigung bekannten Techniken, wie beispielsweise die Anbringung und Verwendung von sogenannten Tooling Holes oder optischen Markern.

Die Ebenen können nach DIN 8593 durch Löten oder Kleben zusammengefügt werden. Die Auswahl der Technik richtet sich nach den Betriebsparametern des Mikroreaktors. Wichtige Betriebsparameter sind die Temperatur, der Druck, mechanische Belastungen und die chemische Zusammensetzung der Reaktionskomponenten. Vorzugsweise wird ein Lötverfahren eingesetzt, da sich bei Anwendung des Umkehrverfahrens die Vorbereitung eines Lötprozesses durch Abscheidung geeigneter Lotschichten in das Herstellverfahren integrieren läßt.

Klebschichten können beispielsweise im Siebdruckverfahren aufgebracht werden. Es werden u.a. Kleber auf der Basis von Epoxidharzen, Acrylatharzen, beispielsweise auch Cyanoacrylatharzen, Polyestern, Polyurethanen, Aminoplasten und Phenolharzen verwendet. Wegen der chemischen Beständigkeit werden Epoxidharze bevorzugt. Bei nachträglicher Vorbehandlung der Fluidkanaloberflächen und Abscheidung von Metallschichten auf diesen Oberflächen können die dem Fluid ausgesetzten Stirnflächen der Klebschichten jedoch versiegelt werden, so daß die chemische Verträglichkeit mit den Fluiden keine Rolle spielt.

Da beim Betrieb des Mikroreaktors an den Stirnflächen des Stapels unter Druck Kräfte auftreten, welche die mechanische Stabilität der äußeren mikrostrukturierten Ebenen übersteigen würden, müssen in geeigneter Weise dimensionierte Frontplatten, die den Stapel abschließen, vorgesehen sein. Diese nehmen die Kräfte auf. Die Fixierung der Frontplatten gegeneinander läßt sich beispielsweise durch eine geeignete Verschraubung realisieren.

In einer bevorzugten Ausführungsform kann die chemische und morphologische Struktur der inneren Reaktoroberfläche nach dem Zusammenfügen des Reaktors modifiziert werden. Hierfür wird geeignetes Fluid (Flüssigkeit, Gas) durch den Reaktor geleitet. Eine derartige Prozeßfolge ist notwendig, wenn die beim Fügen verwendeten Prozeßparameter nicht mit den für die Reaktion optimalen Oberflächen kompatibel sind. Beispielsweise kann die lötbare Zwischenschicht durch außenstromloses Aufbringen einer chemisch beständigeren Nickellegierungsschicht 7 überzogen werden (Verfahrensschritt C in Figur 4). Tritt ferner beim Fügen eine Temperaturerhöhung auf, so kann sich die Oberflächenmorphologie der Metalloberfläche durch Rekristallisation nachteilig verändern. In einem solchen Fall ist es möglich, die Oberflächenstruktur durch das Hindurchleiten einer geeigneten Ätzlösung, beispielsweise zur Erhöhung der Oberflächenrauhigkeit, oder durch Abscheiden einer weiteren Metallschicht zu optimieren. Auch die chemische Zusammensetzung der Oberfläche kann durch den Fügeprozeß gestört werden. Beispielsweise kann sich eine aus mehreren Phasen bestehende Katalysatoroberfläche durch Phasenänderung nachteilig verändern. Trägerfixierte Katalysatoren sind ebenfalls sehr empfindlich gegenüber Temperaturveränderungen.

Die inneren Oberflächen des Mikroreaktors können insbesondere auch dann nachträglich mit einer zusätzlichen Metallschicht überzogen werden, wenn durch die Fügetechnik nur eine unzureichende Dichtigkeit gegenüber den Fluidströmen, die meist unter Druck durch die Kanäle hindurchgefördert werden, erreicht wird. In einem solchen Fall können beispielsweise die ungenügend abgedichteten Fugen zwischen den Ebenen nachträglich durch eine Schicht einer stromlos abgeschiedenen Metallschicht, beispielsweise eine Kupfer- oder Nickelschicht, abgedichtet werden.

In einer konsequenten Nutzung der Möglichkeiten, die sich aus einer dreidimensionalen Verbindungsstruktur ergeben, lassen sich multifunktionelle Reaktortypen realisieren. In diesen sind unterschiedliche Funktionsbereiche komplex miteinander verknüpft. So ist es möglich, mehrstufige Synthesereaktoren, bestehend aus Kaskadenschaltungen aus Misch-, Wärmetauscher- und Reaktionszonen, zu verwirklichen. In einem solchen Modul wird das dreidimensionale Abbild der Kanalstrukturen nach der optimalen Anordnung der verschiedenen Zonen erstellt. Ein Modul läßt sich ähnlich wie ein mikroelektronisches Bauteil über seine Ein- und Ausgänge definieren. Solche Module lassen sich weiter zu neuen Reaktoren kombinieren.

Die nach dem erfindungsgemäßen Verfahren hergestellten Mikroreaktoren können insbesondere zur Herstellung giftiger, instabiler oder explosiver chemischer Produkte nach bekannten Syntheseverfahren eingesetzt werden. Dadurch wird die separate Herstellung dieser Verbindungen vermieden, so daß eine gefährliche Lagerung entfällt. Falls es sich hierbei um zur Weiterverarbeitung bestimmte Zwischenprodukte handelt, werden diese Verbindungen am Produktionsort für das Endprodukt hergestellt und unmittelbar danach in den Reaktor der Produktionsanlage geleitet. Da derartige Verbindungen häufig instabil sind, besteht keine Gefahr, daß sich Teile des hergestellten Zwischenprodukts vor dessen Weiterverarbeitung wieder zersetzen. Des weiteren müssen auch gefährliche Zwischenprodukte nicht mehr separat behandelt werden, wie beispielsweise zur Aufarbeitung und bei der Lagerung.

Nachfolgend werden zur weiteren Erläuterung der Erfindung Herstellbeispiele angegeben.

### Beispiel 1 (Herstellung eines Mikroreaktors durch Anwendung der Ätztechnik und Verbindung einzelner Reaktorebenen durch Verlöten):

Zur Herstellung eines Mikroreaktors/Wärmeaustauschers in Mikrostrukturtechnologie wurde das Ätzverfahren eingesetzt.

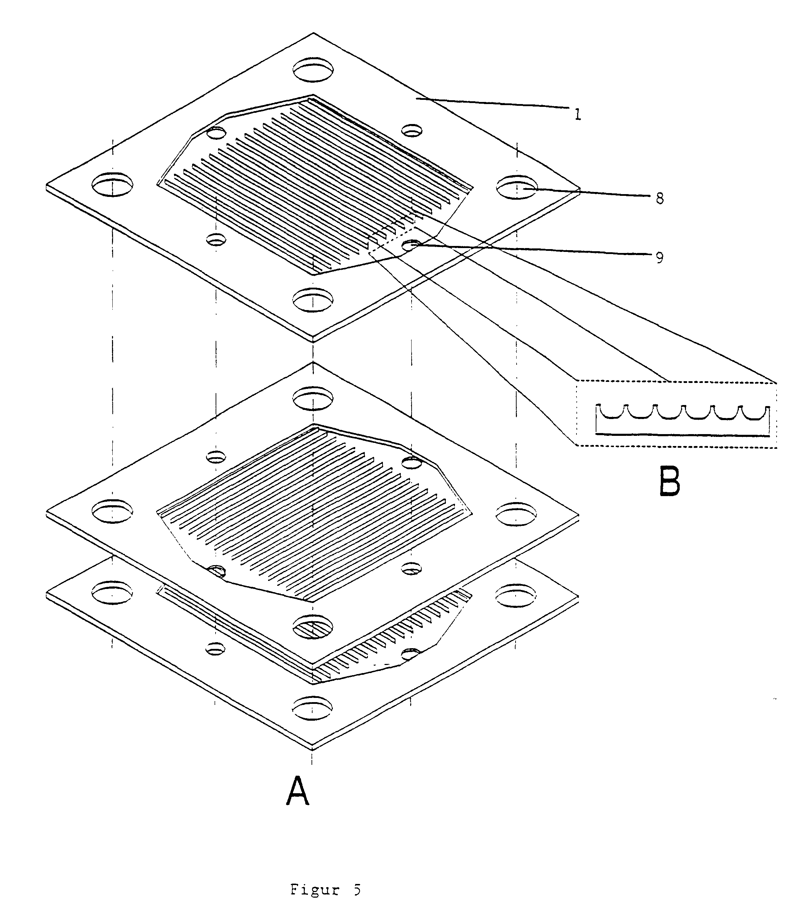

In Figur 5 ist in einem Ausschnitt schematisch die Anordnung von drei aufeinanderfolgenden Kupferblechen dargestellt.

Der Mikroreaktor wurde aus einem Stapel von sechzig Kupferblechen 1 gefertigt. Die Bleche wurden so strukturiert, daß ein Gas- oder Flüssigkeitsstrom in eine Richtung hindurchfließen kann. Die Lagen wurden jeweils um 90° gegeneinander gedreht gestapelt. Damit wurde ein Plattenwärmetauscher für einen Kreuzstrombetrieb gebildet.

Als Substratmaterial zur Herstellung des Wärmetauschers wurden 125 µm dicke Kupferbleche mit Abmessungen von jeweils 150 mm x 150 mm verwendet. Aus diesen Blechen wurden jeweils vier Platten für den Wärmetauscher hergestellt.

Der erste Fertigungsschritt bestand in dem Aufbringen eines photosensitiven, negativ arbeitenden Trockenfilmresists (beispielsweise Riston® 4630 von DuPont de Nemours Inc., USA). Nach dem Belichten des Resists mit dem Layout und Entwickeln wurde aus den freigelegten Bereichen in einer Kupferätzlösung gleichmäßig Kupfer in einer Dicke von 60 um durch Abätzen entfernt. Dadurch entstand eine Kanalstruktur mit einer Kanalbreite von etwa 430 µm, die durch das Layout vorgegeben wurde, einer Kanaltiefe von 60 um und einer Stegbreite von 70 µm. Der Photoresist wurde danach wieder ganzflächig entfernt.

Auf die strukturierten Kupferbleche wurde anschließend eine 4 um dicke Zinn/Blei-Schicht aufgebracht.

Danach wurden die Kupferbleche in vier Segmente zerschnitten, die den einzelnen Lagen im Reaktorpaket entsprachen. Die Segmente waren identisch strukturiert und wurden in der vorbeschriebenen Weise gestapelt.

Als Endplatten des Stapels wurden 5 mm dicke Edelstahlplatten verwendet. Der Stapel wurde durch vier an den Ecken befindliche M8-Schrauben gegeneinander verschraubt. Die hierfür nötigen Löcher 8 wurden wie die notwendigen Gas- bzw. Flüssigkeitsdurchführungen 9 in die Kupferbleche und Edelstahlplatten gebohrt. Im letzten Schritt wurden die Kupferplatten gegeneinander verlötet, indem der Stapel auf 300 °C erhitzt wurde, so daß die Zinn/Blei-Schicht auf den einzelnen Kupferebenen flüssig wurde.

Ein auf diese Weise gefertigter Stapel wies jeweils 2640 Kanäle für jede Flußrichtung mit einer Querschnittsfläche von jeweils 0,7 cm² auf. Die gesamte innere Oberfläche betrug 3000 cm². Die innere Oberfläche war mit einer 4 um dicken Zinn/Blei-Schicht bedeckt.

Für eine spezielle Anwendung zum Einsatz bei einer chemischen Synthese wurde die Zinn/Blei-Schicht durch das Hindurchleiten einer Zinn/Blei-Ätzlösung, die Kupfer nicht angreift, entfernt. In einem weiteren Verfahrensschritt wurde eine extrem dünne Palladiumschicht (beispielsweise 0,02 µm dick) durch zementative Metallabscheidung aufgebracht. Der Mikroreaktor ließ sich dann zur Durchführung heterogen katalysierter Reaktionen verwenden. Da die die einzelnen Ebenen trennenden Kupferbleche einen sehr hohen Wärmeübergangskoeffizient aufwiesen, eignete sich ein solcher Mikroreaktor besonders gut für stark endotherme oder exotherme Reaktionen.

### Beispiel 2 (Herstellung eines Mikroreaktors durch Anwendung der Umkehrtechnik und Verbindung der Reaktorebenen durch Verlöten):

In einem ersten Fertigungsschritt wurde ein photosensitiver Trockenfilmresist (Laminar® HG 2.0 MIL von Morton International GmbH, DE) auf ein Kupfersubstrat aufgebracht (entsprechend Verfahrensschritt A in Figur 1). Nach dem Belichten des Resists mit dem Layout (den herzustellenden Fluidkanälen entsprechende Oberflächenbereiche waren nicht mit Resist bedeckt) und anschließendem Entwickeln wurde in den freigelegten Bereichen galvanisch eine 6 µm dicke Zinn/Blei-Schicht aufgebracht (entsprechend Verfahrensschritte B und C in Figur 1). Diese Schicht diente sowohl als Ätzresist bei der nachfolgenden Strukturierung und als Lotschicht zum Zusammenfügen der einzelnen Lagen.

Der Trockenfilmresist wurde anschließend wieder vollständig entfernt (entsprechend Verfahrensschritt D in Figur 1). Es folgte eine Behandlung mit einer Kupferätzlösung (Eisen(III)-chlorid/Salzsäure), mit der die nicht mit der Zinn/Blei-Schicht abgedeckten Bereiche in einer Dicke von 60 µm abgeätzt wurden (entsprechend Verfahrensschritt E in Figur 1).

Die einen Vierfachnutzen tragenden Kupferbleche wurden danach in vier identisch strukturierte Segmente zerschnitten. Vierzig dieser Einzellagen wurden nach dem Einbringen von Passer-, Montier- und Durchflußbohrungen wie im Herstellbeispiel 1 gestapelt (entsprechend Verfahrensschritt F in Figur 1). zwischen zwei mit Kupfer beschichteten Edelstahlplatten, von denen eine als die obersten Fluidkanäle verschließendes Abschluß-Segment diente, verschraubt und schließlich durch Erhitzen auf etwa 300°C gegeneinander verlötet.

Die innere Oberfläche der derart hergestellten Kanäle war nicht mit einer Zinn/Blei-Schicht überzogen und konnte daher für die Durchführung einer katalysierten chemischen Reaktion direkt durch zementative Metallabscheidung mit einer dünnen Palladiumschicht (aus einer wäßrigen PdSO₄/H₂SO₄-Lösung) überzogen werden.

### Beispiel 3 (Herstellung eines Komposit-Mikroreaktors durch Anwendung der Additivtechnik und Verbindung der Reaktorebenen durch Verkleben):

In einem ersten Fertigungsschritt wurde ein 100 µm dicker Trockenfilmresist auf eine beidseitig mit 25 µm dicken Kupferfolien beschichtete Polyimidfolie (Kapton®-H von DuPont de Nemours Inc., USA) aufgebracht. Nach dem Belichten des Resists mit dem Layout gemäß Figur 5 und anschließendem Entwickeln des Resists, wobei die Stellen auf den Kupferflächen freigelegt wurden, die den zu bildenden Fluidkanälen nicht entsprechen sollten, wurde in den freigelegten Bereichen eine 80 µm dicke Kupferschicht galvanisch abgeschieden. Der Resist wurde anschließend entfernt.

Die wiederum im Vierfachnutzen hergestellten Kupfersubstrate wurden in vier identische, strukturierte Segmente zerschnitten. Zwanzig dieser Einzellagen wurden wie im Herstellbeispiel 1 nach dem Einbringen der Passer-, Montierund Durchflußbohrungen gestapelt.

In diesen Stapel wurde eine Einzellage aus fluoriertem Polyethylen (FEP) nach der nachfolgend beschriebenen Vorbehandlung integriert:

Die etwa 1 mm dicke FEP-Lage (gleiche Größe und Bohrungen wie die Kupferlagen) wurde unter Verwendung von metallorganischen Zusätzen (n-Allyl-ncyclopentadienyl-Palladium-(II)) in einem Radiofrequenz-Plasma (PECVD) mit Palladium-Katalysator beschichtet, die Katalysatorschicht in einem stromlosen Nickelbad mit Natriumhypophosphit als Reduktionsmittel mit einer etwa 1 µm dicken Nickel/Phosphorschicht metallisiert und anschließend galvanisch eine etwa 30 um dicke Kupferschicht aus einem schwefelsauren Kupferbad aufgebracht. Die Kupfer- und Nickel/Phosphor-Schichten wurden mit dem Layout einer geeigneten elektronischen Schaltung nach bekannten Verfahren der Leiterplattentechnik strukturiert. Danach wurden elektronische Bauteile, wie Halbleiterbauelemente (Mikrochips), in die FEP-Lage montiert und an Steuerund Signalleitungen durch Bond- bzw. Lötverfahren angeschlossen.

Sowohl auf zwanzig der strukturierten Polyimid/Kupferlagen als auch auf die FEP-Lage wurde in den Randbereichen außerhalb der Kanalstrukturen ein Zweikomponenten-Kleber auf Epoxidharzbasis dünn aufgetragen. Die Kupferlagen mit der FEP-Lage in der Mitte wurden gestapelt, der Stapel zwischen zwei mit Kupfer beschichteten Edelstahlplatten verschraubt und miteinander verklebt.

Alle offenbarten Merkmale sowie Kombinationen der offenbarten Merkmale sind Gegenstand dieser Erfindung, soweit diese nicht ausdrücklich als bekannt bezeichnet werden.

## Patentansprüche

1. Herstellverfahren für chemische Mikroreaktoren, umfassend mindestens ein Substrat mit Fluidkanälen sowie Zu- und Ableitungen für Fluide ohne Anwendung von Kunststoffabformverfahren mit folgenden Verfahrensschritten:
a. Bilden von Fluidkanalstrukturen auf auf dem Substrat befindlichen Metalloberflächen mittels einer Photoresist- oder einer Siebdrucklackschicht, so daß die Metalloberflächen von der Schicht teilweise bedeckt werden;
b. zumindest teilweises stromloses und/oder elektrochemisches Abätzen von Metall von den freiliegenden Flächen des Substrats;
c. vollständiges Entfernen der Photoresist- oder Siebdrucklackschicht;
d. Bilden von Lotschichten;
e. Übereinanderlegen der Substrate und eines die Fluidkanäle verschließenden Abschluß-Segments und Miteinanderverbinden der Substrate und des Abschluß-Segments durch Löten.

2. Herstellverfahren für chemische Mikroreaktoren, umfassend mindestens ein Substrat mit Fluidkanälen sowie Zu- und Ableitungen für Fluide ohne Anwendung von Kunststoffabformverfahren mit folgenden Verfahrensschritten:
a. Bilden von Fluidkanalstrukturen auf auf dem Substrat befindlichen Metalloberflächen mittels einer Photoresist- oder einer Siebdrucklackschicht, so daß die Metalloberflächen von der Schicht teilweise bedeckt werden;
b. stromloses und/oder elektrochemisches Abscheiden einer Metallschicht auf die freiliegenden Oberflächen des Substrats;
c. vollständiges Entfernen der Photoresist- oder Siebdrucklackschicht;
d. zumindest teilweises stromloses und/oder elektrochemisches Abätzen des Metalls des Substrats unter Bildung von Fluidkanälen;
e. Bilden von Kleb- und/oder Lotschichten;
f. Übereinanderlegen der Substrate und eines die Fluidkanäle verschließenden Abschluß-Segments und Miteinanderverbinden der Substrate und des Abschluß-Segments durch Kleben und/oder Löten.

3. Herstellverfahren für chemische Mikroreaktoren, umfassend mindestens ein Substrat mit Fluidkanälen sowie Zu- und Ableitungen für Fluide ohne Anwendung von Kunststoffabformverfahren mit folgenden Verfahrensschritten:
a. Bilden von Fluidkanalstrukturen auf auf dem Substrat befindlichen Metalloberflächen oder direkt auf dem Substrat mittels einer Photoresist- oder einer Siebdrucklackschicht, so daß die Substratoberflächen oder Metalloberflächen auf dem Substrat von der Schicht teilweise bedeckt werden;
b. Abscheiden einer Metallschicht auf die freiliegenden Oberflächen des Substrats oder auf die Metalloberflächen;
c. vollständiges Entfernen der Photoresist- oder Siebdrucklackschicht;
d. Bilden von Kleb- und/oder Lotschichten;
e. Übereinanderlegen der Substrate und eines die Fluidkanäle verschließenden Abschluß-Segments und Miteinanderverbinden der Substrate und des Abschluß-Segments durch Kleben und/oder Löten.

4. Verfahren nach einem der Ansprüche 1 bis 3, **dadurch gekennzeichnet, daß** das Substrat in Verfahrensschritt a. mit einer Photoresistschicht beschichtet, die Photoresistschicht mit einem positiven oder negativen Abbild der Fluidkanalstruktur belichtet und anschließend entwickelt wird.

5. Verfahren nach einem der vorstehenden Ansprüche, **dadurch gekennzeichnet, daß** ein Substrat mit Oberflächen aus mindestens einem Metall, ausgewählt aus der Gruppe, bestehend aus Stahl, Edelstahl, Kupfer, Nickel und Aluminium verwendet wird.

6. Verfahren nach Anspruch 2, **dadurch gekennzeichnet, daß** in Verfahrensschritt b. mindestens ein Metall, ausgewählt aus der Gruppe, bestehend aus Zinn, Blei, Nickel, Kobalt, Wismut, Silber, Gold und einer Legierung dieser Metalle, stromlos und/oder elektrochemisch aufgetragen wird.

7. Verfahren nach Anspruch 6, **dadurch gekennzeichnet, daß** die Substrate durch Verlöten miteinander verbunden werden, indem die Zinn-, Blei-, Wismut- oder die Legierungsschicht mit dem Metall unter Wärmeeinwirkung verbunden wird.

8. Verfahren nach einem der Ansprüche 6 oder 7, **dadurch gekennzeichnet. daß** in Verfahrensschritt b. auf eine Seite der Substrate eine Zinn- und auf die andere Seite der Substrate eine Wismutschicht aufgetragen wird und daß die Substrate derart aufeinandergelegt werden, daß die Zinn- und die Wismutschichten übereinanderliegen und anschließend miteinander verlötet werden.

9. Verfahren nach einem der vorstehenden Ansprüche, **dadurch gekennzeichnet, daß** Durchgänge in den Substraten gebildet werden.

10. Verfahren nach einem der vorstehenden Ansprüche, **dadurch gekennzeichnet, daß** die Oberflächen der Fluidkanäle nach dem Übereinanderlegen und Miteinanderverbinden der Substrate durch mindestens ein Verfahren, ausgewählt aus der Gruppe, bestehend aus Metallabscheiden, Metallabätzen und Adsorbieren von chemischen Verbindungen oder von anderen chemischen Spezies, modifiziert werden.

11. Verfahren nach Anspruch 10, **dadurch gekennzeichnet, daß** die Oberflächen der Fluidkanäle durch weiteres Abscheiden einer Palladium-, Platin-, Rhodium-, Iridium-, Ruthenium- Schicht und/oder einer Schicht von Legierungen dieser Metalle und/oder einer Nickel/Phosphor-Legierungsschicht als Korrosionsschicht oder zur Bildung katalytischer Oberflächen modifiziert werden.

12. Verfahren nach einem der vorstehenden Ansprüche, **dadurch gekennzeichnet, daß** Ventile und/oder andere Aktoren in den Reaktoren durch Auftragen ferromagnetischer Metallschichten gebildet werden.

13. Verfahren nach einem der vorstehenden Ansprüche, **dadurch gekennzeichnet, daß** Sensoren zur Messung von Eigenschaften durchströmender Fluide und/oder elektrische Leitungen in den Reaktoren gebildet werden.

14. Verfahren nach einem der vorstehenden Ansprüche, **dadurch gekennzeichnet, daß** elektrische Widerstandsheizungen und/oder Kühlelemente in den Reaktoren gebildet werden.

15. Verfahren nach einem der vorstehenden Ansprüche, **dadurch gekennzeichnet, daß** in einzelnen Lagen des aus mehreren Substraten bestehenden Mikroreaktors das Metall in begrenzten Bereichen durch Abätzen vollständig entfernt wird, um lichtdurchlässige Fenster zu bilden.

16. Chemischer Mikroreaktor mit Fluidkanälen in mindestens einer Ebene sowie Zu- und Ableitungen für Fluide, bei dem die Fluidkanäle durch einander gegenüberliegende Seitenwände aus Metall und durch weitere, sich zwischen diesen Seitenwänden erstreckende Seitenwände aus Metall oder Kunststoff begrenzt sind, **dadurch gekennzeichnet, daß** die Ebenen untereinander und/oder mit einem offenliegende Fluidkanäle verschließenden Abschluß-Segment mittels geeigneter Lotschichten verbunden sind.

17. Mikroreaktor nach Anspruch 16, **dadurch gekennzeichnet, daß** die Seitenwände aus mindestens einem Metall, ausgewählt aus der Gruppe, bestehend aus Stahl, Edelstahl, Kupfer, Nickel und Aluminium, gebildet sind.

18. Mikroreaktor nach einem der Ansprüche 16 und 17, **dadurch gekennzeichnet, daß** als Lotschichten Metallegierungen, enthaltend Metalle, ausgewählt aus der Gruppe, bestehend aus Zinn, Blei, Wismut, Antimon und Silber, enthalten sind.

19. Mikroreaktor nach einem der Ansprüche 16 bis 18, **dadurch gekennzeichnet, daß** die Seitenwände mit funktionellen Schichten zur Katalyse und/oder zum Korrosionsschutz überzogen sind.

20. Verwendung des Mikroreaktors nach einem der Ansprüche 16 bis 19 zur Herstellung giftiger, instabiler oder explosiver chemischer Produkte, insbesondere von Chlorcyan, Phosgen, Ethylenoxid, Selenverbindungen, Mercaptanen. Methylchlorid, Methyljodid, Dimethylsulfat, Vinylchlorid und Phosphinen.

## Claims

1. Method for manufacturing chemical microreactors, comprising at least one substrate which has fluid ducts as well as feed and discharge lines for fluids, without using plastics moulding methods, said method having the following method steps:
a. forming fluid duct structures on the metal surfaces situated on the substrate by means of a photoresist layer or a screen-printing lacquer layer, such that the metal surfaces are partially covered by the layer;
b. at least partial currentless and/or electrochemical etching away of metal from the bare surfaces of the substrate;
c. completely removing the photoresist or screen-printing lacquer layer;
d. forming solder layers;
e. superimposing the substrates and a closure segment closing the fluid ducts and interconnecting the substrates and the closure segment by soldering.

2. Method for manufacturing chemical microreactors, comprising at least one substrate which has fluid ducts as well as feed and discharge lines for fluids, without using plastics moulding methods, said method having the following method steps:
a. forming fluid duct structures on metal surfaces situated on the substrate by means of a photoresist layer or a screen-printing lacquer layer, such that the metal surfaces are partially covered by the layer;
b. currentless and/or electrochemical deposition of a metal layer on the bare surfaces of the substrate;
c. completely removing the photoresist or screen-printing lacquer layer;
d. at least partial currentless and/or electrochemical etching away of the metal of the substrate, forming fluid ducts;
e. forming adhesive and/or solder layers;
f. superimposing the substrates and a closure segment closing the fluid ducts and interconnecting the substrates and the closure segment by gluing and/or soldering.

3. Method for manufacturing chemical microreactors, comprising at least one substrate with fluid ducts as well as feed and discharge lines for fluids, without using plastics moulding methods, said method having the following method steps:
a. forming fluid duct structures on metal surfaces situated on the substrate or directly on the substrate by means of a photoresist layer or a screen-printing lacquer layer, such that the substrate surfaces or the metal surfaces on the substrate are partially covered by the layer;
b. depositing a metal layer on the bare surfaces of the substrate or on the metal surfaces;
c. completely removing the photoresist or screen-printing lacquer layer;
d. forming adhesive and/or solder layers;
e. superimposing the substrates and a closure segment closing the fluid ducts and interconnecting the substrates and the closure segment by gluing and/or soldering.

4. Method according to one of claims 1 to 3, **characterised in that** the substrate is coated in method step a. with a photoresist layer, the photoresist layer is exposed with a positive or negative image of the fluid duct structure and then developed.

5. Method according to one of the preceding claims, **characterised in that** a substrate is used which has surfaces formed from at least one metal, selected from the group comprising steel, stainless steel, copper, nickel and aluminium.

6. Method according to claim 2, **characterised in that** in method step b. at least one metal, selected from the group comprising tin, lead, nickel, cobalt, bismuth, silver, gold and an alloy of these metals, is applied by currentless and/or electrochemical means.

7. Method according to claim 6, **characterised in that** the substrates are interconnected by soldering, by the layer of tin, lead, or bismuth or the alloy layer being connected with the metal under the action of heat.

8. Method according to one of claims 6 or 7, **characterised in that** in method step b. a tin layer is applied to one side of the substrates and a bismuth layer to the other side, and **in that** the substrates are superimposed in such a way that the tin layers and the bismuth layers lie the one above the other and are then soldered to each other.

9. Method according to one of the preceding claims, **characterised in that** passages are formed in the substrates.

10. Method according to one of the preceding claims, **characterised in that,** after the superimposition and interconnection of the substrates, the surfaces of the fluid ducts are modified by at least one method selected from the group comprising metal deposition, metal etching and adsorption of chemical compounds or of other chemical species.

11. Method according to claim 10, **characterised in that** the surfaces of the fluid ducts are modified by further deposition of a layer of palladium, platinum, rhodium, iridium or ruthenium and/or a layer of alloys of these metals and/or a nickel/phosphorus alloy layer as a corrosion layer or to form catalytic surfaces.

12. Method according to one of the preceding claims, **characterised in that** valves and/or other actuators are formed in the reactors by applying ferromagnetic metal layers.

13. Method according to one of the preceding claims, **characterised in that** sensors, for measuring the properties of fluids flowing through, and/or electrical lines are formed in the reactors.

14. Method according to one of the preceding claims, **characterised in that** that electrical resistance heating systems and/or cooling elements are formed in the reactors.

15. Method according to one of the preceding claims, **characterised in that** in individual layers of the microreactor which comprises a plurality of substrates, the metal is completely removed by etching in defined areas in order to form translucent windows.

16. Chemical microreactor having fluid ducts in at least one plane as well as feed and discharge lines for fluids, in which microreactor the fluid ducts are delimited by metal side walls facing one another and by additional metal or plastics side walls extending between said side walls, **characterised in that** the planes are connected to each other and/or to a closure segment, which closes fluid ducts lying open, by means of suitable solder layers.

17. Microreactor according to claim 16, **characterised in that** the side walls are formed from at least one metal selected from the group comprising steel, stainless steel, copper, nickel and aluminium.

18. Microreactor according to one of claims 16 and 17, **characterised in that** metal alloys, which contain metals selected from the group comprising tin, lead, bismuth, antimony and silver, are contained as solder layers.

19. Microreactor according to one of claims 16 to 18, **characterised in that** the side walls are covered with functional layers for catalysis and/or as protection against corrosion.

20. Use of the microreactor according to one of claims 16 to 19 for producing poisonous, unstable or explosive chemical products, especially chlorine cyanide, phosgene, ethylene oxide, selenium compounds, mercaptans, methyl chloride, methyl iodide, dimethyl sulphate, vinyl chloride and phosphines.

## Revendications

1. Procédé de fabrication de micro-réacteurs chimiques, comprenant au moins un substrat disposant de canaux de fluide ainsi que des canaux de dérivation et d'alimentation du fluide sans utiliser de procédé de moulage des matières plastiques et en utilisant les étapes de fabrication suivantes :
a. Formation de structures de canaux de fluide sur des surfaces métalliques placées sur le substrat au moyen d'une couche de laque pour sérigraphie ou d'une couche de photorésist, de manière à couvrir partiellement au moyen de la couche les surfaces métalliques ;
b. Corrosion électrochimique et/ou sans courant au moins partielle du métal des surfaces dégagées du substrat ;
c. Enlèvement complet de la couche de laque pour sérigraphie ou de la couche de photorésist ;
d. Formation de couches de brasage ;
e. Superposition des substrats et d'un segment de fermeture obturant les canaux de fluide et raccord des substrats et du segment de fermeture par brasage.

2. Procédé de fabrication de micro-réacteurs chimiques, comprenant au moins un substrat disposant de canaux de fluide ainsi que des canaux de dérivation et d'alimentation du fluide sans utiliser de procédé de moulage des matières plastiques et en utilisant les étapes de fabrication suivantes :
a. Formation de structures de canaux de fluide sur des surfaces métalliques placées sur le substrat au moyen d'une couche de laque pour sérigraphie ou d'une couche de photorésist, de manière à couvrir partiellement au moyen de la couche les surfaces métalliques ;
b. Séparation électrochimique et/ou sans courant d'une couche métallique située sur les surfaces dégagées du substrat ;
c. Enlèvement complet de la couche de laque pour sérigraphie ou de la couche de photorésist ;
d. Corrosion électrochimique et/ou sans courant au moins partielle du métal du substrat lors de la formation de canaux de fluide ;
e. Formation de couches de collage et/ou de brasage ;
f. Superposition des substrats et d'un segment de fermeture obturant les canaux de fluide et raccord des substrats et du segment de fermeture par collage et/ou brasage.

3. Procédé de fabrication de micro-réacteurs chimiques, comprenant au moins un substrat disposant de canaux de fluide ainsi que des canaux de dérivation et d'alimentation du fluide sans utiliser de procédé de moulage des matières plastiques et en utilisant les étapes de fabrication suivantes :
a. Formation de structures de canaux de fluide sur des surfaces métalliques placées sur le substrat ou directement sur le substrat au moyen d'une couche de laque pour sérigraphie ou d'une couche de photorésist, de manière à couvrir partiellement au moyen de la couche les surfaces du substrat ou les surfaces métalliques sur le substrat ;
b. Séparation d'une couche métallique située sur les surfaces dégagées du substrat ou sur les surfaces métalliques ;
c. Enlèvement complet de la couche de laque pour sérigraphie ou de la couche photorésistante ;
d. Formation de couches de collage et/ou de brasage ;
e. Superposition des substrats et d'un segment de fermeture obturant les canaux de fluide et raccord des substrats et du segment de fermeture par collage et/ou par brasage.

4. Procédé selon l'une quelconque des revendications 1 à 3, **caractérisé en ce que** le substrat, lors de l'étape a, est recouvert d'une couche de photorésist, **en ce que** la couche de photorésist est exposée à une image positive ou négative de la structure de canaux de fluide, et **en ce qu'**elle est ensuite développée.

5. Procédé selon l'une quelconque des revendications précédentes, **caractérisé en ce qu'**un substrat disposant de surfaces formées d'au moins un métal choisi parmi le groupe composé de l'acier, l'acier spécial, du cuivre, du nickel et de l'aluminium, est utilisé.

6. Procédé selon la revendication 2, **caractérisé en ce que**, lors de l'étape b, au moins un métal choisi parmi le groupe composé de l'étain, du plomb, du nickel, du cobalt, du bismuth, de l'argent, de l'or et d'un alliage de ces métaux est appliqué sans courant et/ou de manière électrochimique.

7. Procédé selon la revendication 6, **caractérisé en ce que** les substrats sont raccordés les uns aux autres par un processus de brasage lors duquel la couche d'étain, de plomb, de bismuth ou d'alliage est liée au métal par un effet thermique.

8. Procédé selon l'une des revendications 6 ou 7, **caractérisé en ce que**, lors de l'étape b., une couche d'étain est apposée d'un côté des substrats et une couche de bismuth est apposée de l'autre côté des substrats et **en ce que** les substrats sont superposés de manière à ce que les couches d'étain et de bismuth se trouvent les unes au-dessus des autres et soient finalement brasées les unes avec les autres.

9. Procédé selon l'une quelconque des revendications précédentes, **caractérisé en ce que** des ouvertures sont créées dans les substrats.

10. Procédé selon l'une quelconque des revendications précédentes, **caractérisé en ce que** les surfaces des canaux de fluide sont modifiées, après la superposition et le raccord des substrats, par au moins un procédé du groupe composé de la séparation des métaux, la corrosion des métaux, l'adsorption de liaisons chimiques ou d'autres espèces chimiques.

11. Procédé selon la revendication 10, **caractérisé en ce que** les surfaces des canaux de fluide sont modifiées par une autre séparation d'une couche de palladium, de platine, de rhodium, d'iridium, de ruthénium et/ou d'une couche d'alliage de ces métaux et/ou d'une couche d'alliage de nickel et de phosphore en tant que couche de corrosion ou sont modifiées pour former des surfaces catalytiques.

12. Procédé selon l'une quelconque des revendications précédentes, **caractérisé en ce que** les soupapes et/ou autres acteurs dans les réacteurs sont montés par apposition de couches métalliques ferromagnétiques.

13. Procédé selon l'une quelconque des revendications précédentes, **caractérisé en ce que** des capteurs de mesure des propriétés des fluides et/ou conductions électriques circulant sont montés dans les réacteurs.

14. Procédé selon l'une quelconque des revendications précédentes, **caractérisé en ce que** des chauffages ohmiques électriques et/ou des éléments de refroidissement sont montés dans les réacteurs.

15. Procédé selon l'une quelconque des revendications précédentes, **caractérisé en ce que**, dans chaque couche du micro-réacteur composé de plusieurs substrats, le métal est complètement enlevé de certains endroits par corrosion pour former une fenêtre laissant pénétrer la lumière.

16. Micro-réacteur chimique avec des canaux de fluide sur au moins un niveau ainsi qu'avec des canaux de dérivation et d'alimentation du fluide, dans lequel les canaux de fluide sont limités par des parois latérales métalliques opposées et par d'autres parois latérales métalliques ou en plastique s'étendant entre ces parois latérales, **caractérisé en ce que** les niveaux sont reliés les uns en dessous des autres et/ou, au moyen de couches de brasage adéquates, à un segment de fermeture ouvert obturant les canaux de fluide.

17. Micro-réacteur selon la revendication 16, **caractérisé en ce que** les parois latérales sont constituées d'au moins un métal du groupe composé de l'acier, de l'acier spécial, du cuivre, du nickel et de l'aluminium.

18. Micro-réacteur selon l'une des revendications 16 et 17, **caractérisé en ce que** les alliages métalliques comprenant des métaux choisis parmi le groupe composé de l'étain, du plomb, du bismuth, de l'antimoine et de l'argent sont présents sous forme couches de brasage.

19. Micro-réacteur selon l'une des revendications 16 à 18, **caractérisé en ce que** les parois latérales sont recouvertes de couches fonctionnelles pour la catalyse et/ou la protection contre la corrosion.

20. Utilisation du micro-réacteur selon l'une quelconque des revendications 16 à 19, pour la préparation de produits chimiques toxiques, instables ou explosifs, en particulier le chlorocyane, le phosgène, l'oxyde d'éthylène, les liaisons de sélénium, le mercaptane, le chlorure de méthyle, l'iodure de méthyle, le sulfate de diméthyle, le chlorure de vinyle et les phosphines.
